# EUROPÄISCHE PATENTSCHRIFT

(11) **EP 0 927 384 B1**
(45) Veröffentlichungstag und Bekanntmachung des Hinweises auf die Patenterteilung: **06.12.2000**
(21) Anmeldenummer: 97937421.2
(22) Anmeldetag: 06.08.1997
(51) Int. Cl.: G05F 1/573, G06F 13/40, G05F 1/613, H02H 9/00, H01R 12/16

(54) **ANORDNUNG ZUM ANSCHLUSS EINES MODULS IN EINEM GERÄT**
ARRANGEMENT FOR CONNECTION OF A MODULE IN AN APPLIANCE
STRUCTURE DE BRANCHEMENT D'UN MODULE A UN APPAREIL

(30) Priorität: 18.09.1996 DE 19638167
(43) Veröffentlichungstag der Anmeldung: 07.07.1999
(73) Patentinhaber: Fujitsu Siemens Computers GmbH, 81739 München (DE)
(72) Erfinder: RIEKEN, Ralf, D-32805 Horn-Bad Meinberg (DE); FLOTHO, Helmut, D-33181 Fürstenberg (DE)
(74) Vertreter: Zedlitz, Peter, Dipl.-Inf.
(86) Internationale Anmeldenummer: DE9701654
(87) Internationale Veröffentlichungsnummer: WO9812614

(56) Entgegenhaltungen:
- DE-A- 3 926 352
- US-A- 5 010 293
- US-A- 5 210 855
- HERARD J D: "TAKING THE ZAP OUT OF HOT PLUGGING" MACHINE DESIGN, Bd. 62, Nr. 24, 22.November 1990, CLEVELAND, OHIO, USA, Seite 46-48,50,54 XP000176520

## Beschreibung

Die Erfindung betrifft eine Anordnung zum Anschluß eines Moduls an eine eingeschaltete Versorgungsspannung bei einem modular aufgebauten Gerät, insbesondere einer Rechenanlage.

Viele elektrische Geräte sind heutzutage modular aufgebaut, d.h. sie bestehen aus mehreren, als eigenständige Module ausgebildeten Funktionseinheiten, die leicht und einzeln auswechselbar sind, und durch deren Zusammenwirken innerhalb eines Geräts erst dessen vollständige Funktion erreicht wird.

Der Aufbau eines Gerätes in Modultechnik weist gegenüber einem monolithischen Aufbau aus "einem Stück" oder mehreren fest miteinander verbundenen Teilen eine Reihe von Vorteilen auf. So müssen etwa im Falle eines Defekts nicht das gesamte Gerät oder zumindest große Teile davon ausgetauscht werden, sondern es genügt, nur das defekte Modul zu ersetzen. Da die einzelnen Module in der Regel über Steck-, Rast oder Schraubverbindungen im Gerät installiert sind, kann so ein Austausch schnell und einfach, d.h. oft auch von einem Nichtfachmann durchgeführt werden. Man denke dabei nur an die in sog. Steckplätzen in einem Personal Computer installierten "Steckkarten" (Grafik-, Sound- Netzwerkkarten usw.) oder Speichermodule, die meist von den Anwendern selbst installiert oder ausgetauscht werden können.

Von einigen Geräten muß in der Regel eine besonders hohe Betriebssicherheit, d.h. ein Schutz vor einem teilweisen oder gar vollständigen Ausfall verlangt werden. Dies ist u.a. bei Telefonvermittlungen, Sicherungssystemen oder auch bei Rechenanlagen der Fall. Fällt z.B. die Rechenanlage eines Einzelhandelsunternehmens oder eines Versandhauses für nur einen Tag aus, so kann in der Regel an diesem Tag nicht fakturiert werden, d.h. sowohl der Zahlungseingang als auch der Zahlungsausgang sind blockiert und das Unternehmen ist damit für diesen Zeitraum zahlungsunfähig. Für viele Unternehmen könnten sich aus einer derartigen Situation schwerwiegende Folgen ergeben.

Die erforderliche Betriebssicherheit solcher Geräte wird meistens dadurch erzielt, daß alle wichtigen Funktionseinheiten des Geräts als leicht auswechselbare Module ausgebildet sind, die am besten auch noch redundant, d.h. mehrfach als Reserve vorhanden sind. Tritt dann in einem Modul ein Defekt auf, wird automatisch auf eines der Reservemodule umgeschaltet, ohne daß dafür der Betrieb des Gerätes unterbrochen werden muß oder in seinem Umfang beschränkt werden muß. Ist das defekte Modul nicht redundant vorhanden, so bleibt das Gerät zunächst ebenfalls soweit möglich weiter in Betrieb, jedoch ohne dabei auf die Funktionen des auszutauschenden Moduls zurückgreifen zu können. Ein defektes Moduls wird in der Regel vom Gerät gemeldet, so daß es repariert oder durch ein neues Modul ersetzt werden kann. Der Ausbau des defekten Moduls und der Einbau des reparierten oder neuen Moduls erfolgen dabei "unter Spannung", d.h. während das Gerät und der Anschluß des Moduls darin weiterhin mit Spannung versorgt werden. Um dabei Störungen, z.B. Datenverlust in einer Rechenanlage, zu vermeiden, muß zwar in der Regel die Betriebsumgebung des auszutauschenden Moduls, also z.B. der Systembus für die kurze Dauer des Austausches beruhigt werden, so daß das Gerät für diese Zeit nur beschränkt betriebsbereit ist. Das System (Gerät) als Ganzes muß jedoch nicht abgeschaltet werden, sondern kann z.B. in einem Wartezustand (Standby) verweilen. Man spricht daher von "Online-Replacement (OLR)" oder auch "Live Insertion" von Modulen. Im folgenden wird dafür die abkürzende Schreibweise "OLR" verwendet.

Die dabei unmittelbar nach dem (Wieder-)Einbau eines Moduls möglichen Versorgungsströme übertreffen die Stärke der im normalen Betrieb vom Modul aufgenommenen Ströme oft bei weitem. Dies liegt vor allem daran, daß im Modul in der Regel zunächst Kapazitäten (z.B. Stabilisierungskondensatoren) aufgeladen werden müssen, bevor sich die Stromaufnahme auf das für den Betrieb des Moduls normale Maß reduziert. Problematisch sind diese kurzzeitig beim Moduleinbau auftretenden Stromspitzen, wenn dadurch das Modul selbst oder andere Teile des Gerätes beschädigt werden können, oder wenn dadurch die Spannungsversorgung von anderen Geräteteilen/-modulen kurzzeitig soweit absinkt, daß deren korrekte Funktion eingeschränkt oder gar unmöglich wird (Einige Bausteine, z.B. Speicher oder Zähler, reagieren auf ein Absinken ihrer Versorgungsspannung unter einen bestimmten Schwellwert mit einem Reset und damit zu Datenverlust.).

Um zu hohe Ströme beim Online-Replacement von Modulen zu vermeiden, sind die Versorgungseingänge der entsprechenden Module in der Praxis meistens durch strombegrenzende Bauteile, z.B. ohmsche Vorwiderstände, geschützt. Je höher dabei die maximal zulässige Stromstärke ausfällt, desto mehr Platz benötigen in der Regel die strombegrenzenden Bauteile im Modul. Bei leistungsfähigen Rechenanlagen kann die Maximalstromstärke z.B. ^{~}100A oder mehr betragen, so daß sich für die entsprechend zu dimensionierenden Bauteilen in den Modulen ein beträchtlicher Platzbedarf für die OLR-Strombegrenzung ergibt. Damit wird jedoch die Packungsdichte mehrerer Module im Gerät begrenzt.

Die Offenlegungsschrift DE 34 02 845 A1 zeigt einen Baugruppeneinschub mit voreilenden Kontakten, bei dem ein Vorwiderstand zur Strombegrenzung auf der Baugruppe vorgesehen ist.

In der Veröffentlichung "Taking the zap out of hot plugging" von J.D. Herard, Machine Design, Vol. 63 No. 24, S.46, 48, 50, 54 vom 22. Nov 1990, behandelt allgemein das Problem von Stromstößen beim Online-Replacement und regt allgemein voreilende Kontakte und Strombegrenzungen an, ohne daß konkrete Ausgestaltungen angegeben sind.

In dem Dokument DE-A-3 926 352 wird eine Strombegrenzung gezeigt, ohne daß diese durch ein Kontaktelement überbrückt wird.

Der Erfindung liegt die Aufgabe zugrunde, eine für Online-Replacement vorgesehene Anordnung zum Anschluß eines Moduls an die Stromversorgung eines Geräts anzugeben, bei der der im Modul dafür vorzusehende Platzbedarf minimiert ist.

Die Aufgabe wird gelöst durch eine die Merkmale des Anspruchs 1 aufweisende Anordnung zum Anschluß eines Moduls an eine Stromversorgung eines Geräts.

Dabei wird das Modul über eine modulexterne Vorrichtung zur Strombegrenzung an die Stromversorgung des Gerätes angeschlossen. Die Strombegrenzung dient dabei dazu, eine Beschädigung des Gerätes oder des Moduls durch beim Einbau des Moduls kurzzeitig auftretende, hohe Stromspitzen zu verhindern.

Eine derartige Anordnung zum Anschluß eines Moduls an die Stromversorgung in einem Gerät weist gegenüber herkömmlichen Lösungen den Vorteil auf, daß sich durch die Anordnung der Vorrichtung zur Strombegrenzung außerhalb des Moduls der für OLR erforderliche Platzbedarf im Modul deutlich reduziert. Damit können die Abmessungen des Moduls verringert und eine höhere Packungsdichte mehrerer Module im Gerät erreicht werden. Im Gerät dagegen steht mit den dort u.a. zu Kühlzwecken vorgesehenen Hohlräumei in der Regel ausreichend Platz zur Unterbringung des strombegrenzenden Bauteile zur Verfügung. Als weiterer Vorteil der Erfindung kann die Verwendbarkeit von Modulen (z.B. Kaufteilen), die ursprünglich mangels einer eigene] strombegrenzenden Anordnung nicht für OLR ausgelegt wa ren, gewertet werden.

Vorteilhafte Aus- und Weiterbildungen der Erfindung sind Gegenstand der Unteransprüche.

Bei einer ersten Ausgestaltung der Erfindung - Anspruch 2 -wird beim Einbau eines Moduls in ein Gerät eine elektrische Verbindung zwischen dem Gerät und dem Modul durch die Berührung zweier Kontaktelemente hergestellt. Ein erstes Kontaktelement gehört zum Gerät und ist mit dessen Stromversorgung verbunden. Es ist mit einer Vorrichtung zur Strombegrenzung ausgestattet, um ein vor zu hohen Stromspitzen geschütztes Online-Replacement des Moduls zu ermöglichen. Das andere, als Gegenstück zum ersten Kontaktelement ausgebildete Kontaktelement gehört zum Modul und stellt dessen Versorgungseingang dar. Die beiden Kontaktelemente sind dabei so ausgestaltet, daß beim Einbau des Moduls in das Gerät durch die dabei erfolgende Berührung der Kontaktelemente zunächst eine durch die Anordnung zur Strombegrenzung in der möglichen Stromstärke beschränkte, elektrische Verbindung zwischen der Stromversorgung und dem Eingang des Moduls entsteht. Erst kurze Zeit nach der ersten Berührung der Kontaktelemente ergibt sich eine Verbindung unter Wegfall der Strombegrenzung.

Es ist dabei zweckmäßig - Anspruch 3 -, daß das Kontaktelement im Gerät zusammen mit der Anordnung zur Strombegrenzung als auswechselbare Einheit ausgebildet ist. Besonders vorteilhaft ist es dabei - Anspruch 4 -, wenn diese Einheit so ausgebildet ist, daß bei ihrem Einbau ohne zusätzliche Verdrahtung auch ihr Anschluß an die Stromversorgung des Geräts erfolgt. Ein Austausch der Einheit, z.B. nach einer Beschädigung, ist dabei i.a. mit wesentlich weniger Aufwand und Kosten verbunden, als dies bei einer herkömmlichen modulinternen Vorrichtung zur Strombegrenzung der Fall wäre. Die einfache Auswechselbarkeit der aus einem Kontaktelement und der Strombegrenzung bestehenden Einheit ist beispielsweise - nach Anspruch 5 - gewährleistet, wenn die auswechselbare Einheit mittels einer Schraubverbindung im Gerät befestigt ist.

Bei einer Ausführungsform der Erfindung - Anspruch 6 - besteht eines der beiden Kontaktelemente aus zwei voneinander isolierten Teilbereichen, die beim Einbau des Moduls in das Gerät zeitlich nacheinander mit dem anderen Kontaktelement in Berührung kommen. Dabei stellt der als erstes kontaktierende Teilbereich eine Verbindung von dem Gerät und dem Modul unter Einbeziehung der Strombegrenzung her, während der danach kontaktierende zweite Teilbereich eine direkte Verbindung unter Wegfall der Strombegrenzung erzeugt. Diese Ausführugsform der Erfindung stellt eine sehr einfache und kostengünstige Lösung dar, da das Ein- und Ausschalten der Strombegrenzung direkt durch das zeitlich versetzte Kontaktieren der beiden Teilbereiche beim Herstellen der Verbindung zwischen dem Gerät und dem Modul erfolgt, ohne daß dafür noch zusätzliche Schalter oder Regelvorrichtungen erforderlich sind.

Bei einer alternativen Ausgestaltung der erfindungsgemäßen Anordnung - Anspruch 7 - ist das Gerät mit zwei Kontaktelementen versehen, von denen das eine mit dem Modul und das andere mit der Stromversorgung des Geräts leitend verbunden ist. Der Anschluß des Moduls an die Stromversorgung erfolgt mittels eines Verbindungselements, das die beiden Kontaktelemente leitend verbindet und zu dem auch die Vorrichtung zur Strombegrenzung gehört. Dieses Verbindungselement kann dabei entfernt werden, wodurch die Spannungsversorgung des Moduls unterbrochen werden kann. Die beiden Kontaktelemente und das Verbindungselement sind so ausgestaltet, daß beim Anschluß des Verbindungselementes an die beiden Kontaktelemente eine elektrische Verbindung zwischen dem Gerät und dem Versorgungseingang des Moduls aufgebaut wird, bei der die mögliche Stromstärke zunächst durch die Vorrichtung zur Strombegrenzung beschränkt wird, bevor zeitlich verzögert eine Verbindung unter Wegfall der Strombegrenzung erfolgt. Ein besonderer Vorteil dieser Ausgestaltung der Erfindung besteht darin, daß der Einbau eines Moduls in das Gerät spannungslos erfolgen kann, indem das Verbindungselement entfernt und damit die Spannungsversorgung für das Modul unterbrochen wird. Bei einem Gerät, bei dem mehrere Module eingebaut bzw. angeschlossen werden können, werden Verbindungselemente nur für die tatsächlich bestückten Einbauplätzte (Slots) für Module benötigt. Somit werden für leere Einbauplätze keine weiteren Kosten verursacht.

Bei einer zweckmäßigen Ausführungsform - Anspruch 8 - sind die beiden Kontaktelemente als Stromschienen mit angeformten Kontaktzungen ausgebildet, und das Verbindungselement stellt eine Steckerkupplung dar, die auf die Kontaktzungen aufgesteckt ist. Damit ist ein leichtes und schnelles Ein- und Ausbauen des Verbindungselementes möglich.

Dabei ist es zweckmäßig - Anspruch 9 -, daß die Vorrichtung zur Strombegrenzung in das als Steckerkupplung ausgebildete Verbindungselement integriert ist.

Insbesondere kann dabei - nach Anspruch 10 - die Steckerkupplung zwei voneinander isolierte Kontaktbrücken zur elektrischen Verbindung der beiden Stromschienen enthalten, wobei eine erste Kontaktbrücke eine Kurzschlußbrücke darstellt, während in die zweite Kontaktbrücke die Vorrichtung zur Strombegrenzung integriert ist. Die Kontaktbrücken sind jeweils als vor- bzw- nmacheilende Kontakte ausgebildet, so daß beim Aufstecken der Steckerkupplung auf die Kontaktzungen der beiden Stromschienen zunächst die zweite Kontaktbrücke mit den Kontaktzungen der Stromschienen kontaktiert, wobei eine durch die Vorrichtung zur Strombegrenzung in der möglichen Stromstärke beschränkte elektrische Verbindung zwischen den Stromschienen herstellt wird. Erst zeitlich danach kontaktiert auch die Kurzschlußbrücke mit den Kontaktzungen, wobei dann eine elektrische Verbindung der beiden Stromschienen unter Wegfall der Strombegrenzung erfolgt.

Bei einer Ausgestaltung der Erfindung - Anspruch 11 - ist das erste Kontaktelement als Stromschiene in Form eines flachen Stabes ausgebildet, an dem an einer Längskante Lötstifte zur Verbindung mit einer eine elektrische Verbindung zum Modul herstellenden Leiterplatte und an einem Ende der anderen Längskante mindestens eine Kontaktzunge angeformt ist.

Gemäß einer Weiterbildung der erfindungsgemäße Anordnung - Anspruch 12 - ist an das erste als Stromschiene ausgebildete Kontaktelement außer der Kontaktzunge eine weitere Zunge angeformt. Sie paßt beim Aufstecken des als Steckerkupplung ausgebildeten Verbindungselementes in eine spezielle Ausnehmung (HR) in dessen Gehäuse, so daß dabei ein Verpolungsschutz gegen ein verkehrtes Aufstekken erreicht wird.

Die Anordnung zur Strombegrenzung kann - nach Anspruch 13 -, unabhängig von der speziellen Ausführungsform der Anordnung, so ausgelegt sein, daß sie beim Einbau des Moduls neben ihrer stromdämpfenden Funktion zusätzlich als Sicherung wirkt und dabei beim Überschreiten einer Maximalstromstärke die gerade hergestellte elektrische Verbindung zwischen dem Gerät und dem Modul unterbricht. Damit wird eine Beschädigung des Geräts oder des Moduls durch beim Einbau z.B. induktiv hervorgerufene Spannungsspitzen, die trotz der strombegrenzenden Wirkung der entsprechenden Anordnung zu überhöhten Stromstärken führen würden, verhindert.

Dabei kann die Strombegrenzung - Anspruch 14 - durch eine induktiv wirkende Anordnung realisiert sein. Entsprechende Induktivitäten (Drosseln) nehmen auch bei einer Dimensionierung für hohe Ströme nur wenig Raum ein und erzeugen zudem, etwa verglichen mit einem entsprechenden ohmschen Vorwiderstand, deutlich geringere, als Wärme abzuführende Verlustleistungen.

Beim einem solchen Einsatz von strombegrenzenden Induktivitäten ist es zweckmäßig, daß - nach Anspruch 15 - die induktiv wirkende Anordnung durch eine parallel dazu und bezüglich der Stromrichtung des über diese Parallelschaltung fließenden Stromes in Sperrichtung geschalteter Freilaufdiode ergänzt ist. Wenn dann beim Moduleinbau, wie oben beschrieben, eine unmittelbare Verbindung zwischen der Stromversorgung des Geräts und dem Versorgungseingang des Moduls hergestellt wird, sorgt die Freilaufdiode für ein Kurzschließen der Induktivität und damit zum raschen Abbau des darin aufgebauten Magnetfeldes. Unerwünschte, von der Induktivität ausgehende Störimpulse werden somit weitgehend abgefangen.

Im folgenden werden Einzelheiten der Erfindung anhand von Ausführungsbeispielen unter Bezugnahme auf Zeichnungen näher erläutert.

Es zeigt
- FIG 1: in einer Seitenansicht den Aufbau einer Anordnung zum Anschluß eines Moduls gemäß einer ersten Ausgestaltung der Erfindung ;
- FIG 2: ein Ersatzschaltbild der Anordnung zur Erläuterung ihrer Funktionsweise;
- FIG 3: in einer Draufsicht den Aufbau einer Anordnung zum Anschluß eines Moduls gemäß einer anderen Ausgestaltung der Erfindung.
- FIG 4: in einer Seitenansicht das als Steckerkupplung ausge bildete Verbindungselement und die beiden als Stromschienen ausgebildeten Kontaktelemente.

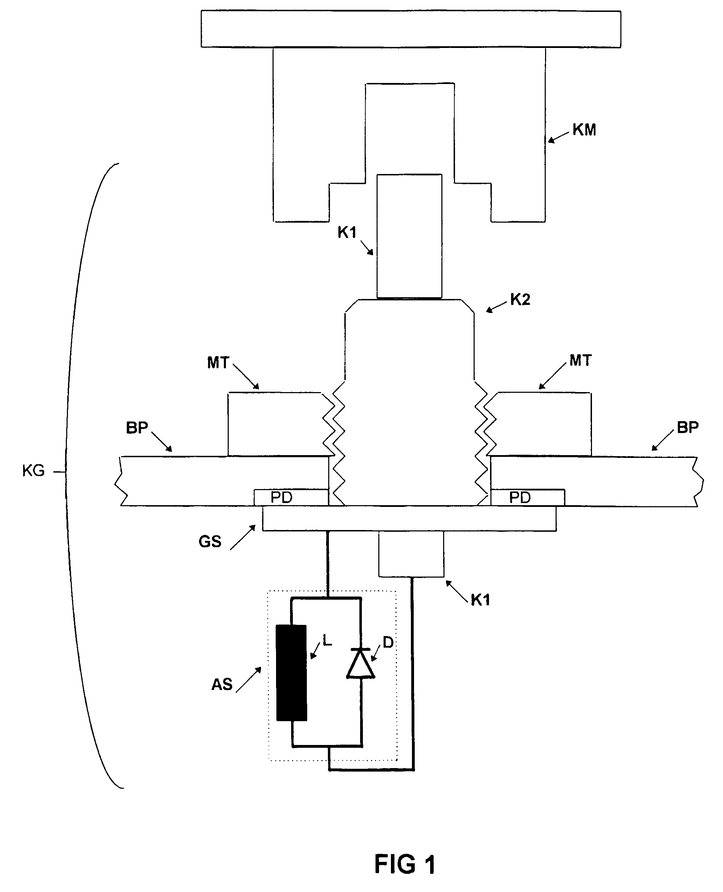

In FIG 1 ist eine erfindungsgemäße Anordnung, bestehend aus einem ersten, zu einem Gerät gehörenden Kontaktelement KG und einem zweiten, zu einem Modul gehörenden Kontaktelement KM dargestellt. In einer Leiterplatte ("Backplane") BP des Gerätes ist das Kontaktelement KG mittels einer Schraubverbindung mit einer Mutter MT und einem Gegenstück GS installiert. Das Kontaktelement KG weist zwei elektrisch leitende, voneinander isolierte Teilbereiche K1 und K2 auf, die der Herstellung einer elektrischen Verbindung mit dem Kontaktelement KM des Moduls dienen, und zusammen damit eine Steckverbindung zwischen dem Gerät und dem Modul darstellen. Dabei ist der eine Teilbereich K1 als voreilender Pin ausgebildet und kontaktiert das Kontaktelement KM des Moduls beim Zusammenfügen der Steckverbindung entsprechend früher als der andere Teilbereich K2. Die Teilbereiche K1 und/oder K2 können dabei jeweils auch mehrere Einzelkontakte/Pins umfassen. Das Kontaktelement KG, d.h. insbesondere sein Teilbereich K2, ist mittels des Gegenstücks GS über eine auf der Leiterplatte BP befindliche Kontaktstelle ("Pad") PD ohne zusätzliche Verdrahtung an eine Stromversorgung des Gerätes angeschlossen. Zwischen die beiden voneinander isolierten Teilbereiche K1 und K2 ist eine als Parallelschaltung aus einer als Induktivität wirkenden Drossel L und einer Diode D ausgebildete Anordnung AS zur Strombegrenzung geschaltet. Das Kontaktelement KG stellt mit der dazugehörigen Anordnung AS zur Strombegrenzung eine leicht und schnell auswechselbare Einheit dar.

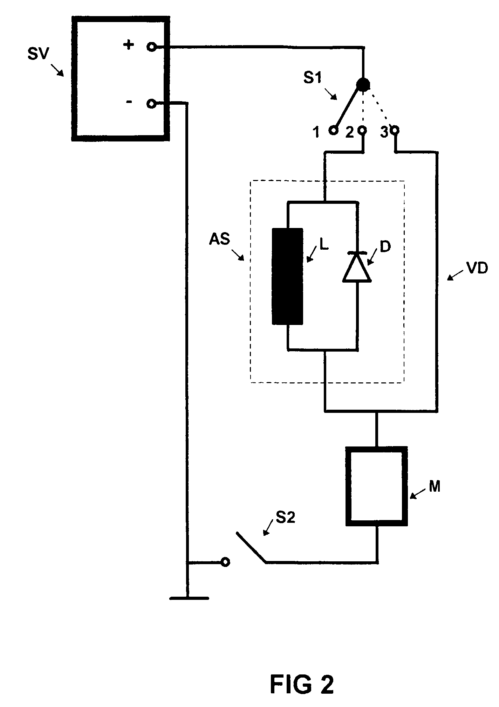

Die Funktionsweise der erfindungsgemäßen Anordnung wird im folgenden anhand eines in FIG 2 dargestellten Ersatzschaltbildes erläutert:

Die Situation vor dem Einbau eines Moduls M in ein Gerät entspricht im Ersatzschaltbild einem Zustand, in dem die beiden Schalter S1 und S2 geöffnet sind (Stellung 1 für S1). Das Modul M ist dabei von einer Stromversorgung SV des Geräts völlig abgetrennt. Beim Einbau des Moduls wird zunächst, z.B. über das Modulgehäuse oder spezielle (in FIG 1 nicht dargestellte) Kontakte eine Masseverbindung des Moduls M mit dem entsprechenden Ausgang der Stromversorgung SV hergestellt. Dies entspricht einem Schließen des Schalters S2.

Als nächstes kommt es zur Kontaktierung eines den Teilbereich K1 darstellenden voreilenden Pins mit dem Kontaktelement KM des Moduls. In FIG 2 ist dies äquivalent zu einem Wechsel der Stellung des Schalters S1 von Position 1 nach 2. Damit ist erstmals eine spannungsführende Verbindung zwischen dem Modul M und der Stromversorgung SV des Geräts hergestellt. Durch die Anordnung AS ist die mögliche Stärke des über diese Verbindung fließenden Stromes nach oben beschränkt. Die Strombegrenzung ergibt sich dabei außer durch den ohmschen Widerstand der Drossel L, vor allem durch deren unmittelbar nach dem Schließen des Schalters S1 auftretenden, induktiven Widerstand. Mögliche Stromspitzen, die beim ersten Berühren der Kontaktelemente KM und KG, bzw. beim Schließen des Schalters S1 auftreten könnten, werden somit gedämpft. Die fließenden Ströme dienen im wesentlichen zum Aufladen von Kondensatoren im Modul M. Die Diode D ist in Sperrichtung geschaltet und spielt zu diesem Zeitpunkt daher keine Rolle. Überschreitet die Stärke des Einschaltstromes trotz der Dämpfung einen erlaubten Höchstbetrag, so kommt es zur Zerstörung, d.h. dem Durchbrennen der entsprechend dimensionierten Drossel L, die in diesem Fall als einen Art Schmelzsicherung für das Modul M dient. Durch einen schnell und kostengünstig ausführbaren Austausch des in die Leiterplatte BP eingeschraubten Kontaktelementes KG läßt sich der Schaden leicht beheben.

Beim Einsteckvorgang, mit dem das Modul M in das Gerät eingebaut wird, kommt es kurze Zeit (einige Milli- bis Zehntelsekunden) nach dem ersten Kontakt des voreilenden Pins K1 auch zu einem Kontakt des Teilbereichs K2 mit dem Kontaktelement KM des Moduls. Dies entspricht in FIG 2 einem Umschalten des Schalters S1 auf Position 3, wobei jedoch die Anordnung AS auch weiterhin mit der Stromversorgung SV verbunden bleiben kann. Damit wird unter Umgehung der Strombegrenzung AS eine unmittelbare Verbindung VD zwischen der Stromversorgung SV und dem Versorgungseingang des Moduls M hergestellt. Da die modulinternen Kondensatoren zu diesem Zeitpunkt bereits weitgehend ihren Betriebszustand (Ladezustand) erreicht haben treten keine gefährlichen Stromspitzen auf und die Spannungsversorgung der anderen im Gerät vorhandenen Einheiten/Module wird nicht über die Maßen belastet. Das in der Drossel L aufgebaute Magnetfeld wird durch den Kurzschluß der Induktivität L über die jetzt in Richtung des Entladestromes geschaltete Freilaufdiode D abgebaut.

Beim Ausbau eines Moduls erfolgt die Auflösung der stromführende Verbindung zwischen dem Modul und dem Gerät nicht schlagartig, sondern unter zeitlicher "Zwischenschaltung" der Strombegrenzung. Die Stromstärke, bei der die tatsächliche Unterbrechung der Verbindung erfolgt, ist daher durch die Strombegrenzung bereits deutlich abgesunken. Die Kontaktelemente werden entsprechend weniger mit Funkenschlag oder Abbrand belastet, als bei einem sofortigen Öffnen der Verbindung ohne Zwischenschaltung der Strombegrenzung.

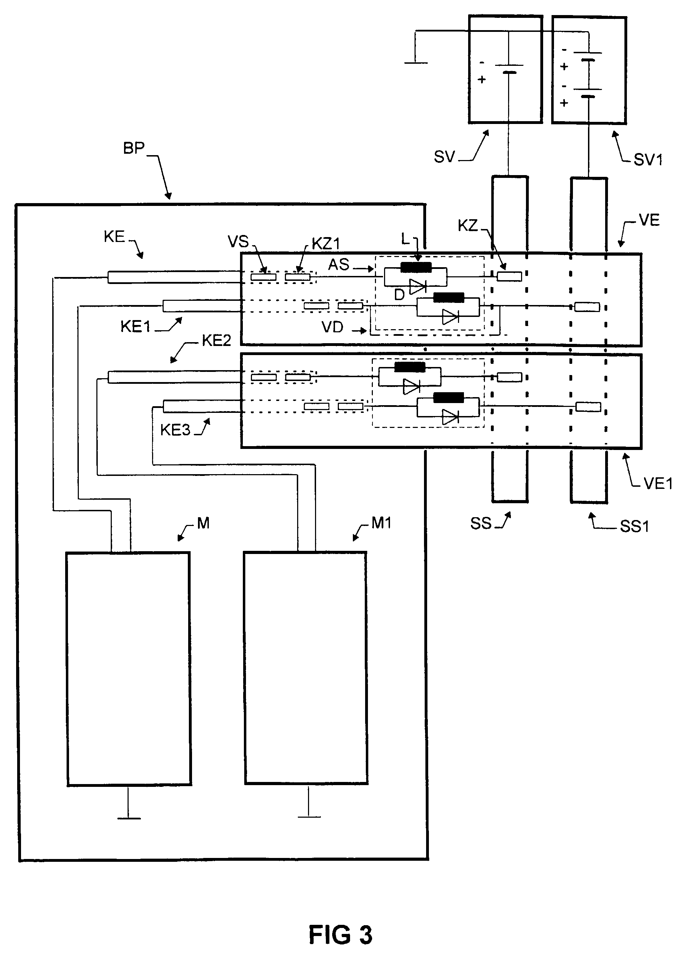

FIG 3 zeigt in einer Draufsicht eine andere Weiterbildung der Erfindung. Die Zeichnung zeigt zwei Module M und M1 eines Gerätes, die jeweils in einen Steckplatz (Slot) auf einer Leiterplatte (Backplane) BP des Geräts installiert sind.

Im Beispiel benötigen beide Module M bzw. M1 jeweils zwei verschiedene Versorgungsspannungen. Sie verfügen daher jeweils über zwei Versorgungseingänge, die jeweils leitend mit je einem Kontaktelement KE, KE1 bzw. KE2, KE3 auf der Leiterplatte BP verbunden sind. Im Gerät werden die entsprechenden Versorgungsspannungen durch die Strom- bzw. Spannungsversorgungen SV und SV1 erzeugt und die als Stromschienen SS bzw. SS1 ausgebildeten Kontaktelemente als Verteiler daran angeschlossen. Der elektrische Anschluß der Module M und M1 erfolgt jeweils durch ein Verbindungselement VE bzw. VE1, das auf je eine entsprechende Kontaktzunge KZ bzw. KZ1 auf einem der Kontaktelemente KE bis KE3 und einer Stromschiene SS bzw. SS1 aufgesteckt wird. Dabei enthalten die Verbindungselemente VE und VE1 jeweils eine Vorrichtung AS zur Strombegrenzung, die z.B. (pro Versorgungsspannung) aus einer Drossel L mit parallelgeschalteter Freilaufdiode D besteht. Die Steckkontakte zwischen den Verbindungselementen und den Kontaktzungen KZ bzw. KZ1 sind als vor- bzw. nacheilende Kontakte so ausgebildet, das beim Aufstecken eines Verbindungselementes VE bzw. VE1 zunächst eine elektrische Verbindung zwischen dem entsprechenden Modul M bzw. M1 und den Stromversorgungen SV und SV1 erfolgt, die durch die Vorrichtung AS zur Strombegrenzung in der möglichen Stromstärke begrenzt ist. Erst kurz danach kommt es mit dem vollständigen Einstecken der Verbindungselemente zu einer direkten Verbindung VD (eingezeichnet nur für den Zweig mit dem Kontaktelement KE1) unter Wegfall bzw. Umgehung der Strombegrenzung.

Auf den Kontaktelementen KE bis KE3 ist noch jeweils eine Erhebung VS vorgesehen, die in eine Vertiefung im Verbindungselement eingreift und einen Verpolungsschutz gegen ein falsches Aufstecken der Verbindungselemente VE bzw. VE1 darstellt.

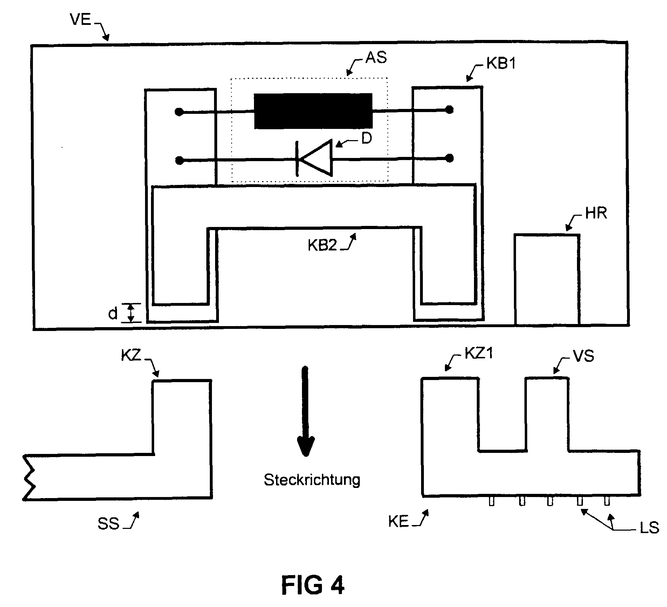

In FIG 4 ist ein als Steckerkupplung ausgebildetes Verbindungselement VE detailierter in einer Seitenansicht dargestellt. Im Gehäuse der Steckerkupplung sind isoliert voneinander eine Kontaktbrücke KB1, die die Vorrichtung AS zur Strombegrenzung enthält, und eine Kurzschlußbrücke KB2 integriert. Beim Aufstecken des Verbindungselementes VE auf die Stromschienen SS und KE stellen die beiden Kontaktbrücken eine elektrische Verbindung zwischen den beiden Stromschienen SS und KE her, wobei die an den beiden Stromschienen SS und KE angeformten Kontaktzungen KZ bzw. KZ1 in das Verbindungselement VE eingreifen und dort nacheinander die Strombrücken KB1 und KB2 kontaktieren. Dabei sind die Kontaktstellen der Kurzschlußbrücke KB2 als gegenüber denen der anderen Kontaktbrücke KB1 als nacheilende Kontakte ausgebildet, indem sie um eine Strecke d in das Innere des Steckergehäuses zurückversetzt sind. Daher kommt es beim Aufstecken des Verbindungselementes VE auf die Stromschienen SS und KE zunächst nur zu einer strombegrenzten Verbindung bevor auch die Kurzschlußbrücke KB2 die Kontaktzungen KZ und KZ1 berührt und eine direkte leitendende Verbindung hergestellt. Die Stromschiene KE ist an einer Längskante mit Lötstiften LS ausgestattet, mit den sie in eine Leiterplatte, z.B. die Backplane eines Rechners, eingelötet ist. Neben der Konzaktzunge KZ1 weist die Stromschiene eine weitere Zunge VS auf, die beim Aufstecken der Stekkerkupplung in eine spezielle Aussparung HR im Steckegehäuse eingreift, wodurch ein Verpolungsschutz gegen ein mit einem seitenverkehrten Aufstecken des Steckers verbundenen Verpolen der Diode D erreicht wird.

## Patentansprüche

1. Anordnung zum Anschluß mindestens eines Moduls (M) an eine Stromversorgung (SV) in einem Gerät derart, daß ein Anschluß bei eingeschalter Stromversorgung (SV) vorgesehen ist,
**dadurch gekennzeichnet**,
daß in dem Gerät ein außerhalb des Moduls befindliches Kontaktelement (KG, VE) vorgesehen ist, welches einen voreilenden Kontakt und eine Vorrichtung zur Strombegrenzung (AS) aufweist, die mit dem voreilenden Kontakt verbunden ist und durch einen nicht voreilenden Kontakt überbrücht wird.

2. Anordnung nach Anspruch 1, wobei
- das Kontaktelement (KG) an dem Gerät befestigt ist,
- das Modul (M) einen Gegenkontakt (KM) aufweist,
- beim Einsetzen des Moduls in das Gerät Kontaktelement (KG) und Gegenkontakt (MM) miteinander verbunden werden.

3. Anordnung nach Anspruch 2, wobei das Kontaktelement (KG) zusammen mit der dazu gehörenden Vorrichtung zur Strombegrenzung (AS) als auswechselbare Einheit ausgebildet ist.

4. Anordnung nach Anspruch 3, wobei bei Installation der auswechselbaren Einheit ohne zusätzlich Verdrahtung auch der Anschluß der Einheit (KG) an die Stromversorgung (SV) des Geräts erfolgt.

5. Anordnung nach Anspruch 3 oder 4, wobei das Kontaktelement (KG) als auswechselbare Einheit mittels einer Schraubverbindung im Gerät befestigbar ist.

6. Anordnung nach einem der Ansprüche 2 bis 5, wobei eines der beiden Kontaktelemente (KG) aus zwei voneinander isolierten Teilbereichen (K1, K2) besteht, die beim Einbringen des Moduls (M) in das Gerät zeitlich nacheinander mit dem anderen Kontaktelement (KG bzw. KM) in Berührung kommen, wobei der als erstes kontaktierende Teilbereich (K1) eine Verbindung von dem Gerät und dem Modul (M) unter Einbeziehung der Strombegrenzung herstellt, während der danach kontaktierende zweite Teilbereich (K2) eine Verbindung unter Wegfall der Strombegrenzung erzeugt.

7. Anordnung nach Anspruch 1,
**dadurch gekennzeichnet**,
- daß das Gerät mit zwei Kontaktelementen (SS, KE) versehen ist, von denen das erste Kontaktelement (KE) mit dem Modul und das zweite Kontaktelement (SS) mit der Stromversorgung (SV) des Geräts leitend verbunden ist;
- daß die beiden Kontaktelemente (SS, KE) durch ein entfernbares Verbindungselement (VE), zu dem auch die Vorrichtung (AS) zur Strombegrenzung gehört, verbunden sind; und
- daß das Verbindungselement (VE) und die beiden Kontaktelemente (SS, KE) so ausgestaltet sind, daß beim Anschluß des Verbindungselements (VE) an die beiden Kontaktelemente (KE, SS) eine elektrische Verbindung zwischen dem Gerät und dem Versorgungseingang des Moduls (M) aufgebaut wird, bei der die mögliche Stromstärke zunächst durch die Vorrichtung (AS) zur Strombegrenzung beschränkt wird, bevor eine Verbindung (VD) unter Wegfall der Strombegrenzung erfolgt.

8. Anordnung nach Anspruch 7, wobei
- die beiden Kontaktelemente (SS, KE) als Stromschienen mit angeformten Kontaktzungen (KZ) ausgebildet sind und
- das Verbindungselement (VE) eine Steckerkupplung darstellt, die auf die Kontaktzungen (KZ, KZ1) aufsteckbar ist.

9. Anordnung nach Anspruch 8, wobei
- die Vorrichtung (AS) zur Strombegrenzung in das als Steckerkupplung ausgebildete Verbindungselement (VE) integriert ist.

10. Anordnung nach Anspruch 9, wobei
- die Steckerkupplung zwei voneinander isolierte Kontaktbrücken (KB1, KB2) zur elektrischen Verbindung der beiden Stromschienen (SS, KE) enthält und
- in eine erste Kontaktbrücke (KB1) die Vorrichtung (AS) zur Strombegrenzung integriert ist und
- die zweite Kontaktbrücke (KB2) eine Kurzschlußbrükke darstellt; und
- die Kontaktbrücken (KB1, KB2) jeweils so ausgebildet sind, daß beim Aufstecken der Steckerkupplung auf die Kontaktzungen (KZ, KZ1) der beiden Stromschienen (SS, KE) zunächst die erste Kontaktbrücke (KB1) mit den Kontaktzungen (KZ, KZ1) der Stromschienen (SS, KE) kontaktiert, wobei eine durch die Vorrichtung (AS) zur Strombegrenzung in der möglichen Stromstärke beschränkte elektrische Verbindung zwischen den Stromschienen (SS, KE) herstellt wird,
- und zeitlich danach die Kurzschlußbrücke (KB2) mit den Kontaktzungen (KZ, KZ1) kontaktiert, wobei eine elektrische Verbindung der beiden Stromschienen (SS, KE) unter Wegfall der Strombegrenzung erfolgt.

11. Anordnung nach einem der Ansprüche 8 bis 10, wobei
- das erste Kontaktelement (KE) als Stromschiene in Form eines flachen Stabes ausgebildet ist, an dem an einer Längskante Lötstifte (LS) zur Verbindung mit einer eine elektrische Verbindung zum Modul (M) herstellenden Leiterplatte (BP) und
- an einem Ende der anderen Längskante mindestens eine Kontaktzunge (KZ1) angeformt ist.

12. Anordnung nach einem der Ansprüche 8 bis 11, wobei
- an das erste als Stromschiene ausgebildete Kontaktelement (KE) außer der Kontaktzunge (KZ1) eine weitere Zunge (VS) angeformt ist, die beim Aufstekken als Steckerkupplung ausgebildeten Verbindungselementes (VE) in eine Ausnehmung (HR) in dessen Gehäuse eingreift, wodurch ein Verpolungsschutz erreicht wird.

13. Anordnung nach einem der vorhergehenden Ansprüche, wobei die Vorrichtung zur Strombegrenzung (AS) so ausgelegt ist, daß sie während des Einbaus des Moduls (M) zusätzlich als Sicherung dient und dabei beim Überschreiten einer Maximalstromstärke die gerade hergestellte elektrische Verbindung zwischen der Stromversorgung (SV) und dem Modul (M) unterbricht.

14. Anordnung nach einem der vorhergehenden Ansprüche, wobei die Strombegrenzung durch eine induktiv wirkende Vorrichtung (L) realisiert ist.

15. Anordnung nach Anspruch 14, wobei die induktiv wirkende Vorrichtung (L) durch eine parallel dazu und bezüglich der Stromrichtung des über diese Parallelschaltung fließenden Stromes in Sperrichtung geschalteter Freilaufdiode (D) ergänzt ist.

## Claims

1. Arrangement for connecting at least one module (M) to a power supply unit (SV) in an apparatus in such a way that a connection is provided when the power supply unit (SV) is switched on, characterized in that provided in the apparatus is a contact element (KG, VE) which is located outside the module and has leading contacts and a device for current limitation (AS).

2. Arrangement according to Claim 1, in which
- the contact element (KG) is fastened to the apparatus,
- the module (M) has a mating contact (KM), and
- the contact element (KG) and mating contact (KM) are interconnected when the module is inserted into the apparatus.

3. Arrangement according to Claim 2, in which the contact element (KG) is constructed together with the device belonging thereto for current limitation (AS) as an exchangeable unit.

4. Arrangement according to Claim 3, in which, upon installation of the exchangeable unit, the unit (KG) is also connected to the power supply unit (SV) of the apparatus without additional wiring.

5. Arrangement according to Claim 3 or 4, in which the contact element (KG) can be fastened in the apparatus as an exchangeable unit by means of a screwed connection.

6. Arrangement according to one of Claims 2 to 5, in which one of the two contact elements (KG) comprises two mutually insulated subregions (K1, K2) which, upon insertion of the module (M) into the apparatus, come into contact sequentially in time with the other contact element (KG or KM), the subregion (K1), which is the first to make contact, making a connection between the apparatus and the module (M) in conjunction with current limitation, while the second subregion (K2), which makes contact thereafter, makes a connection in conjunction with the elimination of the current limitation.

7. Arrangement according to Claim 1, characterized
- in that the apparatus is provided with two contact elements (SS, KE), of which the first contact element (KE) is conductively connected to the module and the second contact elements (SS) is conductively connected to the power supply unit (SV) of the apparatus;
- in that the two contact elements (SS, KE) are connected by a removable connecting element (VE) to which the device (AS) for current limitation also belongs;
- in that the connecting element (VE) and the two contact elements (SS, KE) are configured such that, upon connection of the connecting element (VE) to the two contact elements (KE, SS), an electric connection is built up between the apparatus and the supply input of the module (M), in the case of which the possible current strength is initially limited by the device (AS) for current limitation before a connection (VD) is made in conjunction with the elimination of the current limitation.

8. Arrangement according to Claim 7, in which
- the two contact elements (SS, KE) are constructed as busbars with integrally formed contact tongues (KZ), and
- the connecting element (VE) constitutes a plug-in coupling which can be plugged onto the contact tongues (KZ, KZ1).

9. Arrangement according to Claim 8, in which
- the device (AS) for current limitation is integrated into the connecting element (VE), which is constructed as a plug-in coupling.

10. Arrangement according to Claim 9, in which
- the plug-in coupling contains two mutually insulated contact bridges (KB1, KB2) for electrically connecting the two busbars (SS, KE), and
- the device (AS) for current limitation is integrated into a first contact bridge (KB1), and
- the second contact bridge (KB2) constitutes a shorting jumper; and
- the contact bridges (KB1, KB2) are constructed in each case such that, when the plug-in coupling is plugged onto the contact tongues (KZ, KZ1) of the two busbars (SS, KE), first of all the first contact bridge (KB1) makes contact with the contact tongues (KZ, KZ1) of the busbars (SS, KE), an electric connection of limited possible current strength being made between the busbars (SS, KE) by the device (AS) for current limitation,
- and thereafter the shorting jumper (KB2) makes contact with the contact tongues (KZ, KZ1), an electric connection being made between the two busbars (SS, KE) in conjunction with the elimination of the current limitation.

11. Arrangement according to one of Claims 8 to 10, in which
- the first contact element (KE) is constructed as a busbar in the form of a flat bar on which soldering pins (LS) are integrally formed on one longitudinal edge for the purpose of connection to a printed circuit board (BP) making an electric connection to the module (M), and
- at least one contact tongue (KZ1) is integrally formed on one end of the other longitudinal edge.

12. Arrangement according to one of Claims 8 to 11, in which
- apart from the contact tongue (KZ1), there is integrally formed on the contact element (KE), which is constructed as a busbar, a further tongue (VS), which, when the connecting element (VE) which is constructed as a plug-in coupling, is plugged on, engages in a cutout (HR) in the housing of said connecting element, thus providing reverse voltage protection.

13. Arrangement according to one of the preceding claims, in which the device for current limitation (AS) is designed such that, during installation of the module (M), it serves additionally as a fuse and in so doing interrupts the electric connection just made between the power supply unit (SV) and the module (M) upon overshooting of a maximum current strength.

14. Arrangement according to one of the preceding claims, in which the current limitation is implemented by an inductively acting device (L).

15. Arrangement according to Claim 14, in which the inductively acting device (L) is supplemented by a freewheeling diode (D) which is connected in parallel therewith and in the blocking direction with respect to the direction of flow of the current flowing via this parallel circuit.

## Revendications

1. Dispositif pour le raccordement d'au moins un module (M) à une alimentation en courant (SV) dans un appareil de telle sorte qu'un raccordement est prévu alors que l'alimentation en courant (SV) est branchée,
caractérisé par le fait qu'il est prévu dans l'appareil un élément de contact (KG, VE) qui se trouve en dehors du module et qui comporte un contact avancé et un dispositif de limitation de courant (AS) qui est relié au contact avancé et qui est ponté par un contact non avancé.

2. Dispositif selon la revendication 1, dans lequel
- l'élément de contact (KG) est fixé à l'appareil,
- le module (M) comporte un élément de contact (KM) complémentaire,
- lors du montage du module dans l'appareil, l'élément de contact (KG) et l'élément de contact (KM) complémentaire sont reliés.

3. Dispositif selon la revendication 2, dans lequel l'élément de contact (KG) et le dispositif de limitation de courant (AS) associé sont conçus ensemble comme une unité échangeable.

4. Dispositif selon la revendication 3, dans lequel, lors de l'installation de l'unité échangeable sans câblage supplémentaire, il s'effectue aussi un raccordement de l'unité (KG) à l'alimentation en courant (SV) de l'appareil.

5. Dispositif selon la revendication 3 ou 4, dans lequel l'élément de contact (KG) comme unité échangeable peut être fixé dans l'appareil au moyen d'un assemblage à vis.

6. Dispositif selon l'une des revendications 2 à 5, dans lequel l'un des deux éléments de contact (KG) est constitué de deux parties (K1, K2) qui sont isolées l'une de l'autre et qui, lors de l'insertion du module (M) dans l'appareil, viennent en contact l'une après l'autre avec l'autre élément de contact (KG ou KM), la première partie venant en contact (K1) établissant une liaison entre l'appareil et le module (M) en incluant la limitation de courant tandis que la deuxième partie venant après en contact (K2) établit une liaison sans la limitation de courant.

7. Dispositif selon la revendication 1,
caractérisé par le fait que
- l'appareil est muni de deux éléments de contact (SS, KE) dont le premier élément de contact (KE) est en liaison conductrice avec le module et le deuxième élément de contact (SS) avec l'alimentation en courant (SV) de l'appareil ;
- les deux éléments de contact (SS, KE) sont reliés par un élément de liaison (VE) qui peut être enlevé et auquel le dispositif de limitation de courant (AS) appartient aussi ; et
- l'élément de liaison (VE) et les deux éléments de contact (SS, KE) sont conçus de telle sorte que, lors du raccordement de l'élément de liaison (VE) aux deux éléments de contact (KE, SS), il s'établit entre l'appareil et l'entrée d'alimentation du module (M) une liaison électrique dans laquelle l'intensité de courant possible est d'abord limitée par le dispositif de limitation de courant (AS) avant qu'une liaison (VD) sans limitation de courant s'établisse.

8. Dispositif selon la revendication 7, dans lequel
- les deux éléments de contact (SS, KE) sont conçus comme des barres de courant avec des languettes de contact (KZ) et
- l'élément de liaison (VE) représente un connecteur à fiche qui peut être enfiché sur les languettes de contact (KZ, KZ1).

9. Dispositif selon la revendication 8, dans lequel
- le dispositif de limitation de courant (AS) est intégré dans l'élément de liaison (VE) conçu comme un connecteur à fiche.

10. Dispositif selon la revendication 9, dans lequel
- le connecteur à fiche contient deux ponts de contact (KB1, KB2) isolés l'un de l'autre et destinés à la liaison électrique des deux barres de courant (SS, KE), et
- le dispositif de limitation de courant (AS) est intégré dans un premier pont de contact (KB1), et
- le deuxième pont de contact (KB2) représente un pont de court-circuit ; et
- les ponts de contact (KB1, KB2) sont conçus chacun de telle sorte que, lors de l'enfichage du connecteur à fiche sur les languettes de contact (KZ, KZ1) des deux barres de courant (SS, KE), le premier pont de contact (KB1) est d'abord mis en contact avec les languettes de contact (KZ, KZ1) des barres de contact (SS, KE), une liaison électrique limitée à l'intensité de courant possible par le dispositif de limitation de courant (AS) étant établie entre les barres de courant (SS, KE),
- le pont de court-circuit (KB2) est ensuite mis en contact avec les languettes de contact (KZ, KZ1), une liaison électrique des deux barres de courant (SS, KE) s'effectuant sans limitation de courant.

11. Dispositif selon l'une des revendications 8 à 10, dans lequel
- le premier élément de contact (KE) est conçu comme une barre de courant sous la forme d'une barre plate sur laquelle sont formés sur une arête longitudinale, des plots de brasage (LS) pour la liaison avec une carte imprimée (BP) établissant une liaison électrique vers le module (M) et
- sur une extrémité de l'autre arête longitudinale, au moins une languette de contact (KZ1).

12. Dispositif selon l'une des revendications 8 à 11, dans lequel,
- outre la languette de contact (KZ1), il est formé sur le premier élément de contact (KE) conçu comme barre de courant une autre languette (VS) qui, lors de l'enfichage de l'élément de liaison (VE) conçu comme connecteur à fiche, s'engage dans un évidement (HR) dans le boîtier de ce dernier, ce qui donne une protection contre toute erreur de polarisation.

13. Dispositif selon l'une des revendications précédentes, dans lequel le dispositif de limitation de courant (AS) est conçu de telle sorte qu'il sert en plus de fusible pendant l'insertion du module (M) et que, lors du dépassement d'une intensité de courant maximale, il interrompt la liaison électrique qui vient d'être établie entre l'alimentation en courant (SV) et le module (M).

14. Dispositif selon l'une des revendications précédentes, dans lequel la limitation de courant est mise en oeuvre par un dispositif (L) agissant par induction.

15. Dispositif selon la revendication 14, dans lequel le dispositif (L) agissant par induction est complété par une diode de roue libre (D) branchée en parallèle et dans le sens bloquant par rapport au sens du courant passant par ce montage parallèle.
